# EUROPEAN PATENT APPLICATION

(11) **EP 1 867 591 A1**
(43) Date of publication of application: **19.12.2007**
(21) Application number: 07006599.0
(22) Date of filing: 29.03.2007
(51) Int. Cl.: B65G 49/06, H01L 21/00, H01L 21/673, H01L 21/677, H01L 21/67

(54) **Conveying system**

(30) Priority: 14.06.2006 JP 2006164324
(71) Applicant: MURATA KIKAI KABUSHIKI KAISHA, Minami-ku Kyoto-shi Kyoto 601 (JP)
(72) Inventor: Fukazawa, Hiroshi, Kyoto-shi Kyoto (JP); Fukushima, Masazumi, Oaza Hashizume, Inuyama-shi, Aichi (JP); Yamamoto, Makoto, Kyoto-shi Kyoto (JP)
(74) Representative: Liedl, Christine

(57) **Abstract**

The present invention provides a conveying system (50) that enables the automation of handling of individual tray (1) and multiproduct small lots to improve the conveying efficiency thereof, while maintaining cleanliness. The conveying system (50) includes a tray loading and unloading means (20) for loading and unloading a plurality of stacked trays (1) into and from a pod (5) and a pod conveying means (10) for conveying said pod (5).

## Description

### Field of the Invention

The present invention relates to conveying systems which are provided in factories manufacturing semiconductor substrates, liquid crystal display panels or the like and which, in order to allow plate-like workpieces (semiconductor wafers or glass plates) used as raw materials for semiconductor substrates to undergo various processing treatments in clean rooms, convey a plurality of the plate-like workpieces each contained in a tray, at a time or one by one.

### Background of the Invention

In factories that manufacture semiconductor substrates, liquid crystal display panels or the like, it is necessary to keep plate-like workpieces (semiconductor wafers or glass plates) used as raw materials, as planar as possible and to avoid damage to the workpieces. It is also necessary to enable the workpieces to be stacked and to minimize a stacking height in order to save a handling space. To meet these requirements, proposals have been made of trays that contain these plate-like workpieces (hereinafter also simply referred to as "workpieces").

Storage containers that contain stacked trays have also been proposed. For example, the Unexamined Japanese Patent Application Publication (Tokkai) No. 2005-191419 (Figures 1 to 4) proposes a storage container that contains stacked trays each containing one semiconductor wafer.

However, the Unexamined Japanese Patent Application Publication (Tokkai) No. 2005-191419 (Figures 1 to 4) does not describe a tray loading and unloading means for loading stacked trays into a storage container (hereinafter referred to as a "pod") or a means for destacking the stacked trays for subsequent processing treatments and stacking a plurality of trays again which contain treated workpieces

On the other hand, to improve production efficiency, a great demand has been made to take advantage of the characteristics of the above tray to automate tray handling in the clean room of the factory using the tray loading and unloading means, the tray stacking and destacking means and the like, while maintaining cleanliness. Further, these tray handling means have been requested to deal with multiproduct small lots and to improve conveying efficiency.

### Summary of the Invention

An object of the present invention is to solve the above problems to provide a conveying system which enables the automation of handling of each tray, the handling of multiproduct small lots, and the improvement of conveying efficiency, while maintaining cleanliness.

The conveying system set forth in Claim 1 is characterized by comprising a tray loading and unloading means for loading and unloading a plurality of stacked trays into and from a pod, and a pod conveying means for conveying the pod.

The conveying system set forth in Claim 2 is dependent on Claim 1 and is characterized by further comprising a tray conveying means for conveying the tray and a tray stacking and destacking means for stacking a plurality of the trays between the tray conveying means and the pod conveying means or destacking the plurality of stacked trays.

The conveying system set forth in Claim 3 is dependent on Claim 1 and is characterized in that the pod has a bottom lid on which a plurality of the stacked trays are placed, and the tray loading and unloading means elevates and lowers the bottom lid relative to a top shell of the pod.

The conveying system set forth in Claim 1 is characterized by comprising the tray loading and unloading means for loading and unloading the plurality of stacked trays into and from the pod and the pod conveying means for conveying the pod. This enables handling of each tray to be automated, allowing the tray to be efficiently conveyed in a clean condition.

The conveying system set forth in Claim 2 further comprises the tray conveying means for conveying the tray, and the tray stacking and destacking means for stacking the plurality of the trays between the tray conveying means and the pod conveying means or destacking the plurality of stacked trays. Thus, in addition to exerting the effects of Claim 1, the conveying system enables the selection of one-by-one conveyance or bulk conveyance.

According to the conveying system set forth in Claim 3, the pod has the bottom lid on which the plurality of stacked trays are placed, and the tray loading and unloading means elevates and lowers the bottom lid relative to the top shell of the pod. Thus, in addition to exerting the effects of Claim 1, the conveying system enables stacked trays to be easily loaded and unloaded.

Other features, elements, processes, steps, characteristics and advantages of the present invention will become more apparent from the following detailed description of preferred embodiments of the present invention with reference to the attached drawings.

### Brief Description of the Drawings

Figure 1A is a general layout showing an example of a conveying system in accordance with the present invention, and Figure 1B is a sectional view of an essential part of Figure 1A.
Figure 2A is a diagram conceptually showing a cross section of a pod in Figure 1, Figure 2B is a diagram conceptually showing a longitudinal section of Figure 2A, Figure 2C is a detailed diagram of an essential part of the pod in Figure 2A with its bottom lid closed, and Figure 2D is a detailed diagram of an essential part of the pod in Figure 2A with its bottom lid open.
Figure 3A and Figure 3B are diagrams illustrating the operations and effects of tray loading and unloading means in Figure 1.
Figure 4A is a plan view of tray stacking and destacking means in Figure 1, Figure 4B is a side view of Figure 4A, and Figure 4C is a sectional view of an essential part of the tray stacking and destacking means gripping a tray.

### Detailed Description of the Preferred Embodiment

An embodiment (working example) of the present invention will be described below with reference to the drawings.

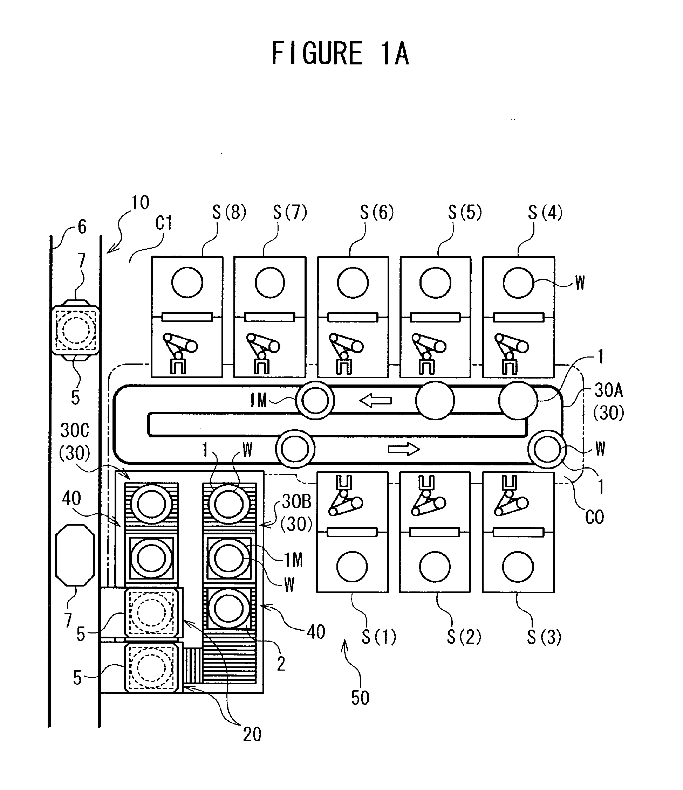

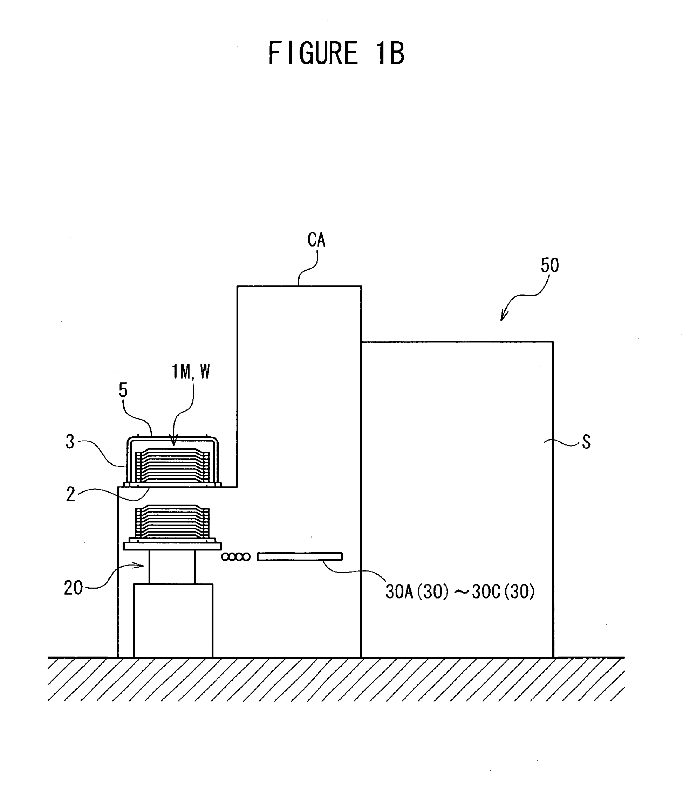

Figure 1A is a general layout of an example of a conveying system in accordance with the present invention. Figure 1B is a sectional view of an essential part of the conveying system.

A conveying system 50 shown in the figures is provided in a factory manufacturing semiconductor substrates, liquid crystal display panels or the like. To allow plate-like workpieces (semiconductor wafers or glass plates) used as raw materials for semiconductor substrates to undergo various processing treatments in a clean room, the conveying system 50 conveys a plurality of the plate-like workpieces each contained in a tray, at a time or one by one.

A description will be given below of an example in which in a factory manufacturing semiconductor substrates, the conveying system handles plate-like workpieces W (hereinafter also simply referred to as "workpieces") that are circular semiconductor wafers contained in a similarly circular tray 1. However, the shapes of the workpieces and tray to which the present invention is related are not limited to those described above.

The conveying system 50 comprises the trays 1 each containing one workpiece W, a bottom lid 2 on which a plurality of stacked trays 1 are placed, a top shell 3 airtightly instal led on the bottom lid 2 from above, with a plural ity of the trays 1 stacked on the bottom lid 2 (a tray housing container composed of the bottom lid 2 and the top shell 3 is called a pod 5), a pod conveying means 10 for conveying the pod 5, a tray loading and unloading means 20 for loading and unloading a plurality of stacked trays into and from the pod 5, a tray conveying means 30 for conveying the trays, and a tray stacking and destacking means 40.

In the figures, a reference character S is a processing treatment station in which the conveying system 50 is installed to execute one of the processing treatments for a semiconductor manufacturing process. The processing treatment stations are denoted as S(1), ..., S(4), S(5) and so on, counterclockwise from the left end of the lower stage in the figure.

The processing treatment station S takes the workpiece W out of the tray 1, executes a predetermined processing treatment on the workpiece W, and then returns the workpiece W to the tray 1.

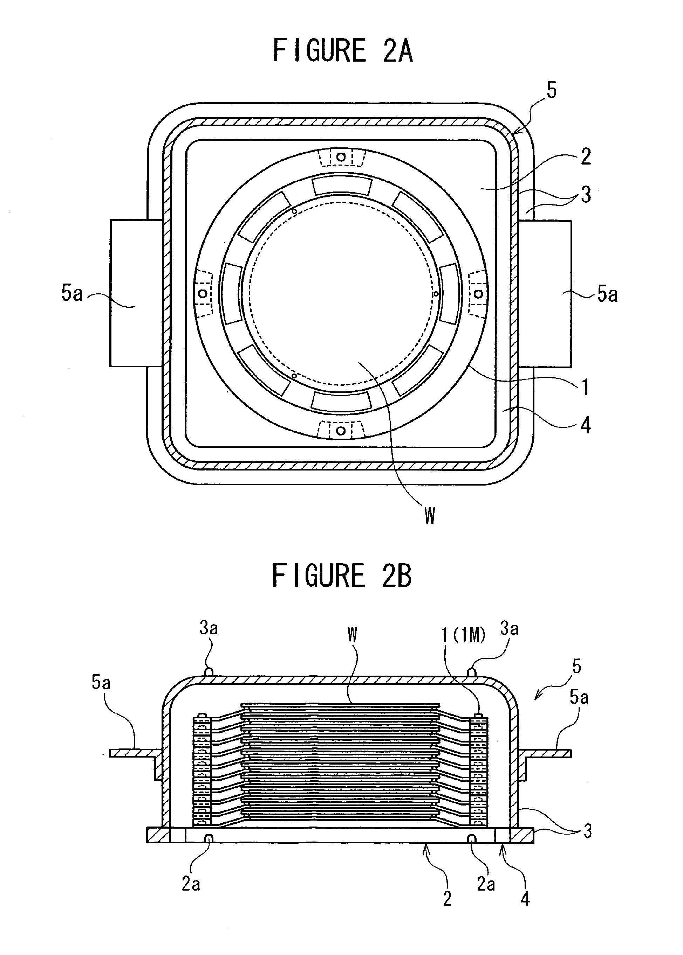

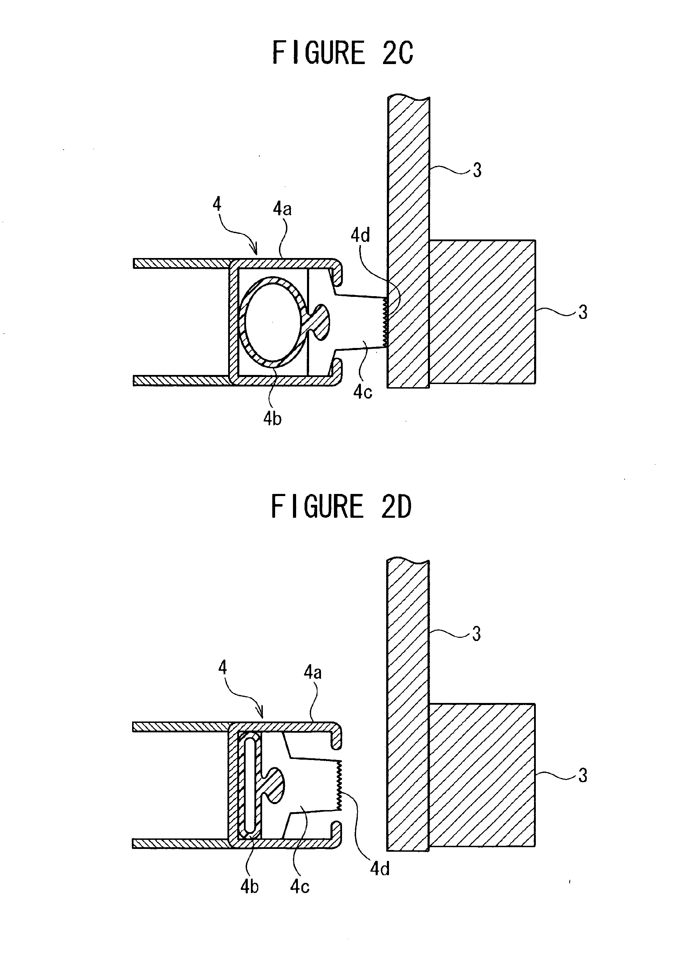

The pod 5, composed of the tray 1, the bottom lid 2 and the top shell 3 will be described below in detail with reference to Figure 2.

The pod conveying means 10 conveys a certain number of the workpieces W, that is, the tray 1, between each of the processing treatment processes. Specifically, as described above, the pod conveying means 10 conveys the pod 5 containing a plurality of the stacked trays 1 each containing one workpiece W; the plurality of stacked trays 1 are denoted as 1M.

The pod conveying means 10 is of a vehicle type that travels on a floor surface. The pod conveying means 10 comprises a predetermined route 6 and a plurality of vehicles 7 that are automatically controlled to travel along the route 6.

Accordingly, although the pod conveying means 10 is used in an inter-process conveying space C1 that is a clean environment with a relatively low cleanliness, it is not contaminated with particles (particle such as dust) in the inter-process conveying space C1 with a low cleanliness because the workpieces W and the trays 1 are contained in the airtight pod 5 during conveyance.

The pod conveying means 10 is illustrated as the vehicle type traveling on the floor surface. However, the present invention is not limited to this and the pod conveying means 10 may be of an overhead traveling type or a conveyor type.

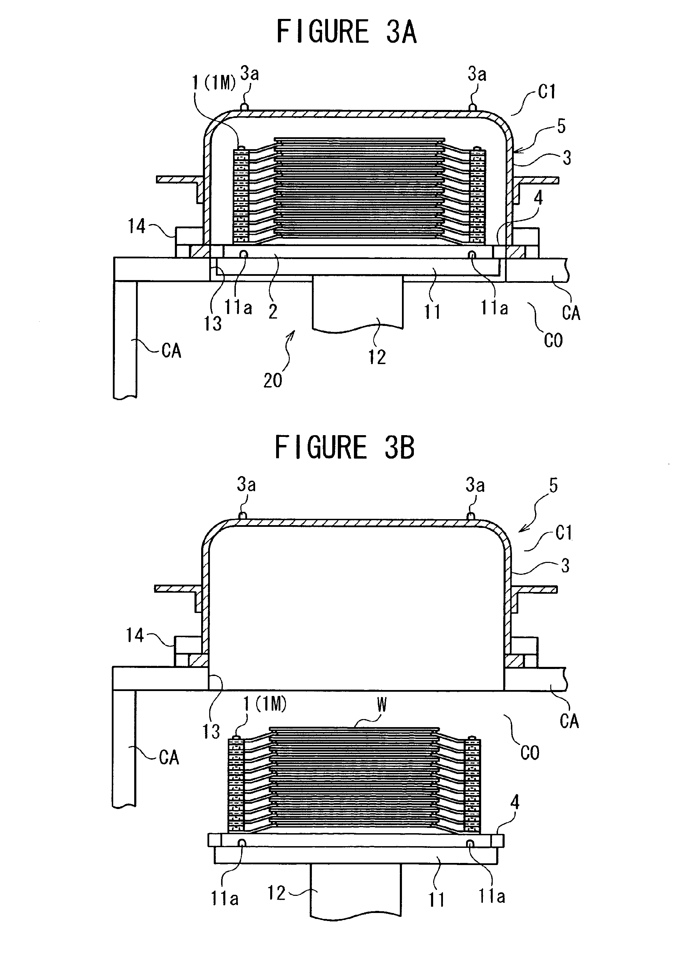

The tray loading and unloading means 20 will be described below with reference to Figure 3.

The tray conveying means 30 comprises a tray conveying means 30A for conveying the tray 1 to each of the processing treatment stations S(1) to S(8), a tray conveying means 30B for conveying the tray 1 from the tray stacking and destacking means 40 to the tray conveying means 30A, and a tray conveying means 30C for conveying the tray 1 from the tray conveying means 30A to the tray stacking and destacking means 40.

As the tray conveying means 30, a roller conveyor, a belt conveyor or the like may be used. However, the present invention is not limited to this and the tray conveying means 30 has only to be able to smoothly convey the tray 1, including its curved portion, in the clean environment.

The tray conveying means 30 may convey the trays I one by one (one-by-one conveyance) or may convey a plurality of the stacked trays 1 at a time.

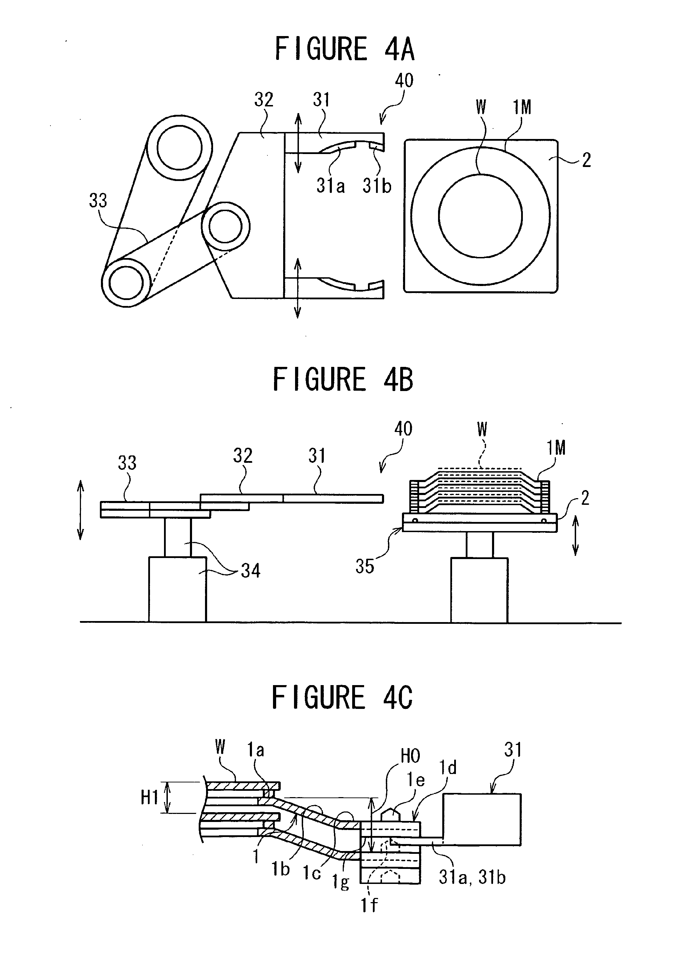

The tray stacking and destacking means 40 will be described below with reference to Figure 4.

Like in each of the processing treatment stations S(1) to S(8), the space in which the tray loading and unloading means 20, the tray conveying means 30, and the tray stacking and destacking means 40 are provided offers a higher cleanliness than the inter-process conveying space C1 with a low cleanliness, in which the pod conveying means 10 is provided. The former space is called an intra-process conveying space C0.

Figure 2A is a conceptual cross section of the pod 5 in Figure 1. Figure 2B is a conceptual longitudinal section of the pod 5 in Figure 2A. Figure 2C is a detailed diagram of an essential part of the pod 5 with its bottom lid 2 closed. Figure 2D is a detailed diagram of the essential part of the pod 5 with its bottom lid 2 open. The already descried parts are denoted by the same reference numerals, with duplicate descriptions omitted.

The bottom lid 2, constituting the pod 5, is shaped like a square. A plurality of the stacked trays 1 can be placed on the bottom lid 2, and an air tube seal means 4 is provided along the four outer edges of the bottom lid 2.

The air tube seal means 4 comprises a housing cylinder 4a surrounded by a square cylinder with one side partly open, an air tube 4b contained in the housing cylinder 4a and which contracts and expands, and a seal 4c having a projecting portion 4d which, in conjunction with the contraction or expansion of the air tube 4b, moves between an inner position and a projecting position relative to an opening portion of the housing cylinder 4a.

Fitting recesses 2a are formed on the underside of the bottom lid 2, that is, opposite the side on which the tray 1 is placed. The fitting recesses 2a are used to position the pods 5 relative to each other in a horizontal direction when the pods 5 are stacked in a vertical direction. The fitting recesses 2a are unnecessary if the pods 5 need not be stacked in the vertical direction.

The top shell 3 is a structure having a sufficient strength to withstand even the vertically stacked pods 5 each containing the tray 1. The top shell 3 itself can be kept airtight.

The lower opening in the top shell 3 is shaped to extend along the outer edge of the bottom lid 2, including the air tube seal means 4. A gap is formed between the inner edge of the lower opening and the outer edge of the bottom lid 2, and has such a size as does not hinder the free flow of air. The gap is opened and closed by the air tube seal means 4.

Fitting projections 3a are provided at an upper edge of the top shell 3 in association with the fitting recesses 2a in the bottom lid 2 to allow the pods 5 to be positioned in the horizontal direction when the pods 5 are stacked in the vertical direction. The fitting projections 3a are also unnecessary if the pods 5 need not be stacked in the vertical direction.

The top shell 3 has a handle 5a projected from its side surface. The handle 5a is used to allow an operator to, for example, lift the pod 5 by holding its part other than the bottom lid 2. For example, when the pod 5 containing the tray 1 is not so heavy, the handle 5a can be conveniently used to manually lift the pod 5 at the work site. However, the handle 5a may be omitted if it is unnecessary.

The height of the top shelf 3 can be freely varied in response to the number of stacked trays 1 to be contained in the pod 5. In this case, the gap between the top shell 3 and the bottom lid 2 (including the air tube seal means 4) allows any top shelf 3 to be used for the same bottom lid 2; the height of the top shell 3 can be varied without relying on the bottom lid 2. This increases the degree of freedom of the height of the pod 5, that is, the degree of freedom of the number of trays 1 contained in the pod 5.

Such a high degree of freedom cannot be provided by a conventional side-open cassette having a plurality of shelf plates on which workpieces are placed.

Further, the tray I used in this case has a structure described below with reference to Figure 4 to enable the stacking height of the workpieces W to be reduced to a fraction of that of the conventional cassette. This enables the height of the top shell 3 required to accommodate the same number of workpieces W in the prior art to be reduced to a fraction.

Thus, the idea of the inventors of the conveying system in accordance with the present invention is such that instead of simply increasing the number of trays 1 (or workpieces W) accommodated by setting the height of the top shell 3 similar to that of the conventional cassette, the above characteristics of the tray 1 are utilized to allow a small number of workpieces as a basic unit to be contained in one pod 5 and, for bulk conveyance, to allow multiple pods 5 each provided with the fitting recesses 2a and the fitting projections 3a to be stacked.

This allows smaller number of workpieces to be conveyed during each operation, making it possible to deal with multiproduct small lots, and this improves conveying efficiency.

That is, the pod 5 in accordance with the present invention has the combination of the bottom lid 2, on which a plurality of the above trays 1 are stacked, and the top shell 3, which is compatible with the bottom lid 2 but can maintain airtightness, through the use of the air tube seal means 4. This makes it possible to deal with multiproduct small lots to improve conveying efficiency, as described above.

Figure 3A and Figure 3B are diagrams illustrating the operation and effects of the tray loading and unloading means 20 in Figure 1.

In the present invention, since the pod 5 itself allows a plurality of the trays 1 to be stacked on the bottom lid 2, and also allows the bottom lid 2 and the top shell 3 to be easily unsealed and separated from each other without any resistance through the use of the air tube seal means 4 described above, the tray loading and unloading means 20, which loads and unloads the tray 1M, has only to have a very simple structure that elevates and lowers the bottom lid 2, as seen in Figure 1B.

Here, the structure of the tray loading and unloading means 20 is specifically shown. The tray loading and unloading means 20 has a pod receiving plate 11 provided on an elevating and lowering means 12 that can be ordinarily used in clean rooms and fitting the bottom lid 2 of the pod 5.

Where the bottom lid 2 has the fitting recesses 2a, the pod receiving plate 11 preferably has fitting protrusions 11a that fit the fitting recesses 2a. This allows the tray loading and unloading means 20 and the pod 5 to be reliably positioned in the horizontal direction.

Further, the tray loading and unloading means 20 is provided on a horizontal part of a partition wall CA that separates the inter-process conveying space C1 with a lower cleanliness from the intra-process conveying space C0 with a higher cleanliness. The pod receiving plate 11 fits into an opening 13 in the tray loading and unloading means 20.

A retainer plate 14 is provided around the periphery of the opening 13; the retainer plate 14 holds a lower edge of the top shell 3 of the pod 5 placed on the pod receiving plate 11 and is movable forward and backward.

The tray loading and unloading means 20 configured as described above operates as described below to exert certain effects.

When the pod 5 is placed in the area of the partition wall CA in which the tray loading and unloading means 20 is disposed, the top shell 3 is fixed by the retainer plate 14. In this state, the bottom lid 2 of the pod 5 is also placed on the pod receiving plate 11 of the tray loading and unloading means 20.

Then, the bottom lid 2 and the top shell 3 are unsealed through the use of the air tube seal means 4 to allow the bottom lid 2 to be separated from the top shell 3 without any resistance. This state is shown in Figure 3A.

Then, when the elevating and lowering means 12 lowers the pod receiving plate 11, the conveying system is brought into the state shown in Figure 3B. The trays 1M stacked on the bottom lid 2 are thus taken out and placed in the intra-process conveying space C0 with a higher cleanliness. That is, the tray loading and unloading means 20 allows the trays 1 to be very easily taken out of and placed in the pod 5.

In this case, the bottom lid 2 lowers to open the lower opening in the upper shell 3, so that a negative pressure is likely to be generated inside the top shell 3. However, the generation of a negative pressure can be prevented by the gap between the contracted air tube seal means 4 and the top shell 3, which has such a size as does not resist the flow of air. This further makes it possible to inhibit particles carried by an air current caused by the negative pressure from being attached to the trays 1M inside the top shell 3 or the workpieces W contained in each tray 1.

Further, the air current is generated in the intra-process conveying space C0 with a higher cleanliness. This enables a reduction in the adverse effect of the particles.

That is, the pod 5 and the corresponding pod conveying means 10 and the tray loading and unloading means 20 in accordance with the present invention allow the exertion of the above effect of the pod 5 and the above effect of the pod conveying means 10, which operates in the inter-process conveying space C1 with a lower cleanliness, as well as the above effect of the tray loading and unloading means 20, which moves the trays 1 from the inter-process conveying space C1 to the intra-space conveying space C0. As a whole, handling of each tray 1 can be automated, and the trays 1 can be efficiently conveyed in a clean state.

With the bottom lid 2 removed, the top shell 3 serves as the partition wall CA between the inter-process conveying space C1 and the intra-process conveying space C0. This inhibits the flow of air between the inter-process conveying space C1 and the intra-process conveying space C0 to prevent the cleanliness of the intra-process conveying space C0 from being affected by the cleanliness of the inter-process conveying space C1.

Further, the top shell 3 is compatible with the bottom lid 2 as described above. Accordingly, when a plurality of the trays 1 already subjected to processing treatments are stacked on the bottom lid 2 standing by as described above and the bottom lid 2 is thus prepared, then the bottom lid 2 is lifted by the tray loading and unloading means 20 and placed in the top shell 3 to form a pod 5, which is then conveyed by the pod conveying means 10.

Thus, the pod 5, the combination of the bottom lid 2 and the top shell 3 in accordance with the present invention, which are compatible with each other, is combined with the tray loading and unloading means 20, which elevates and lowers only the bottom lid 2, to enable flexible conveyance utilizing compatibility between the bottom lid 2 and the top shell 3.

Figure 4A is a plan view of the tray stacking and destacking means 40 in Figure 1. Figure 4B is a side view of Figure 4A. Figure 4C is a sectional view of an essential part of the tray stacking and destacking means 40 gripping the tray.

The tray stacking and destacking means 40 comprises a pair of a tray gripping means 31 that can grip the trays 1 one by one, a slide holding means 32 for holding the pair of tray gripping means 31 so that the opposite distance between the tray gripping means 31 is variable, a free arm 33 installed at one end of the slide holding means 32 so that the direction of the slide holding means 32 is controllable, and an elevating and lowering means 34 for supporting a base end of the free arm 33 so that the free arm 33 can be elevated and lowered.

Further, the tray stacking and destacking means 40 comprises a bottom lid elevating and lowering means 35 for placing the bottom lid 2 with the stacked trays placed thereon so that the bottom lid 2 can be elevated and lowered. Provided that the tray gripping means 31 is able to elevate and lower, the bottom lid elevating and lowering means 35 need not be able to elevate and lower.

Now, with reference to Figure 4C, a description will be given of the configuration of an essential part of the tray 1 in accordance with the present invention to which the tray stacking and destacking means 40 is applicable. The tray 1 includes the same essential part of the tray described in the Japanese Patent Application (Tokugan) No. 2005-214156, the applicant's prior application.

The tray 1 as a whole is shaped like a hat with a flange shaped like a circular truncated cone widened toward its end. The tray 1 has an upper side portion 1a on which the workpieces W are placed, an inclined portion 1b that retains the entire structural strength, and a lower side root portion 1c which can grip the tray 1 and to which a stacking block 1d is assembled.

The stacking block 1d comprises a fitting projection 1e and a fitting recess If which are used to position the vertical trays 1 to be stacked and the stacking block 1d, and a gripping notch portion 1g that forms a predetermined gap between the upper stacking block 1d and the lower stacking block 1d.

When the trays 1 are stacked, only the stacking blocks 1d receive the load of the stacked trays 1. This prevents the workpieces W placed on the tray 1 from being affected.

The inclined portions 1b of the upper and lower trays 1 mate with each other, while retaining the strength of the trays 1, and this enables the height H1 of the stacked workpieces W to be set smaller than the height H0 of the tray 1 itself.

The inclined portion 1b retains the strength of the tray 1, and the stacking block 1d has the gripping notch portion 1g. Thus, fitting the gripping protrusions 31a, 31b of the tray gripping means 31 into the gripping notch portion 1g enables the single tray 1 to be gripped without deforming the tray 1 or affecting the workpieces W placed on the tray 1.

Further, in this case, even if a plurality of the trays 1 are stacked on the gripped tray 1, gripping of the tray 1 can be achieved with the plurality of trays 1 remaining stacked state without being affected by these trays 1.

Moreover, enabling this method for gripping eliminates the need for the gap between the upper and lower workpieces W, which is required where the workpieces W are directly gripped; in the latter case, the gap is required to allow taking-out means to move in and out so that the entire surfaces of the workpieces W can be placed on the taking-out means, in order to reduce deformation of the workpieces W.

As a result, as described above, the use of the trays 1 enables the stacking height to be reduced to a fraction of that of the conventional cassette, with which each workpiece W is placed directly on the corresponding stage.

As is obvious from the above description, when the trays 1 are stacked and destacked by the tray stacking and destacking means 40, the tray gripping means 31 is set at a predetermined height so that its gripping protrusions 31a, 31b can enter the gripping notch portion 1g to allow the trays 1 to be gripped one by one before stacking or destacking.

In this case, in connection with the number of trays 1 staked on the gripped tray 1, any number of trays 1, for example, two or three trays, can be stacked or destacked.

The tray stacking and destacking means 40 is provided between the tray conveying means 30 and the pod conveying means 10 to enable the selection of conveyance of one unit of the trays 1 (including one-by-one conveyance) or bulk conveyance using the pod 5 (conveyance of a given number of trays 1 at a time).

Where the trays 1 at any vertical positions are to be selectively destacked from the stacked trays 1M by the tray stacking and destacking means 40, another tray stacking and destacking means 40 may be installed so that after one of the tray stacking and destacking means 40 picks up a plurality of undesired upper trays 1, the other tray stacking and destacking means 40 can grip and destack a desired number of trays 1.

Alternatively, with the single tray stacking and destacking means 40, a temporary placement area may be prepared so that the undesired trays 1 are temporarily transferred to the temporary placement area, the desired trays 1 can be destacked.

The inventive concept of the conveying system in accordance with the present invention also lies in the point that the range of conveyance conventionally limited to the interior of the inter-process conveying space C1 with a low cleanliness is expanded to the intra-process conveying space C0 with a high cleanliness in order to improve the cleanliness of the conveyance as a whole as well as efficiency. With this regard, the conveying system in accordance with the present invention is a breakthrough against the conventional one.

In the above embodiment, the specific examples of the present invention have been described in detail. However, these are only illustrative and do not limit the claims. The technique described in the claims, that is, the technical scope of the present patent invention, embraces variations or modifications of the above specific examples as appropriately described herein.

The conveying system in accordance with the present invention can be used in industrial fields that need to enable the automation of handling of each tray, the handling of multiproduct small lots, and the improvement of conveying efficiency, while maintaining cleanliness.

While the present invention has been described with respect to preferred embodiments thereof, it will be apparent to those skilled in the art that the disclosed invention may be modified in numerous ways and may assume many embodiments other than those specifically set out and described above. Accordingly, it is intented by the appended claims to cover all modifications of the present invention that fall within the true spirit and scope of the invention.

## Claims

1. A conveying system **characterized by** comprising a tray loading and unloading means for loading and unloading a plurality of stacked trays into and from a pod and a pod conveying means for conveying the pod.

2. A conveying system according to Claim 1, **characterized by** further comprising a tray conveying means for conveying the tray and a tray stacking and destacking means for stacking a plurality of the trays between the tray conveying means and the pod conveying means or destacking the plurality of stacked trays.

3. A conveying system according to Claim 1, **characterized in that** the pod has a bottom lid on which a plurality of the stacked trays are placed, and the tray loading and unloading means elevates and lowers the bottom lid relative to a top shell of the pod.
